(19) **Europäisches Patentamt**

**European Patent Office**

**Office européen des brevets**

(11) **EP 1 390 771 B1**

(12) **EUROPEAN PATENT SPECIFICATION**

(45) Date of publication and mention
of the grant of the patent:
**30.11.2005 Bulletin 2005/48**

(51) Int Cl.⁷: **G01R 31/36**, H01M 8/04

(21) Application number: **02729728.2**

(86) International application number:
**PCT/CA2002/000791**

(22) Date of filing: **29.05.2002**

(87) International publication number:
**WO 2002/097460 (05.12.2002 Gazette 2002/49)**

(54) **FUEL CELL VOLTAGE MONITORING**

ÜBERWACHUNG DER BRENNSTOFFZELLENSPANNUNG

SYSTEME ET PROCEDE DE SURVEILLANCE DE TENSION DE CELLULES ELECTROCHIMIQUES

(84) Designated Contracting States:
**AT BE CH CY DE DK ES FI FR GB GR IE IT LI LU MC NL PT SE TR**

(30) Priority: **29.05.2001 US 865562**

(43) Date of publication of application:
**25.02.2004 Bulletin 2004/09**

(73) Proprietor: **Hydrogenics Corporation Mississauga, Ontario L5R 1B8 (CA)**

(72) Inventors:
• **MASSE, Stéphane**
  **Toronto, Ontario M6P 2T6 (CA)**
• **GOPAL, Ravi, B.**
  **Toronto, Ontario M3M 2C6 (CA)**

(74) Representative: **Harrison, Michael Charles et al Albihns GmbH,
Bayerstrasse 83
80335 München (DE)**

(56) References cited:
**WO-A-01/14898**

• **PATENT ABSTRACTS OF JAPAN vol. 2000, no. 06, 22 September 2000 (2000-09-22) & JP 2000 092732 A (DENSO CORP), 31 March 2000 (2000-03-31)**
• **PATENT ABSTRACTS OF JAPAN vol. 013, no. 433 (E-824), 27 September 1989 (1989-09-27) & JP 01 160367 A (TOSHIBA ELECTRIC EQUIP CORP), 23 June 1989 (1989-06-23)**

**Description**

## FIELD OF THE INVENTION

The present invention relates to a voltage monitoring system and a method for measuring individual cell voltages. The invention has particular, but not exclusive, application to a fuel cell stack in which fuel cells are stacked in series.

## BACKGROUND OF THE INVENTION

A fuel cell is an electrochemical device that produces an electromotive force by bringing the fuel (typically hydrogen) and an oxidant (typically air) into contact with two suitable electrodes and an electrolyte. A fuel, such as hydrogen gas, for example, is introduced at a first electrode where it reacts electrochemically in the presence of the electrolyte to produce electrons and cations in the first electrode. The electrons are circulated from the first electrode to a second electrode through an electrical circuit connected between the electrodes. Cations pass through the electrolyte to the second electrode. Simultaneously, an oxidant, such as oxygen or air is introduced to the second electrode where the oxidant reacts electrochemically in the presence of the electrolyte and a catalyst, producing anions and consuming the electrons circulated through the electrical circuit. The cations are consumed at the second electrode. The anions formed at the second electrode or cathode react with the cations to form a reaction product. The first electrode or anode may alternatively be referred to as a fuel or oxidizing electrode, and the second electrode may alternatively be referred to as an oxidant or reducing electrode. The half-cell reactions at the first and second electrodes respectively are:

$$H_2 \rightarrow 2H^+ + 2e^- \tag{1}$$

$$1/2O_2 + 2H^+ + 2e^- \rightarrow H_2O \tag{2}$$

The external electrical circuit withdraws electrical current and thus receives electrical power from the fuel cell. The overall fuel cell reaction produces electrical energy as shown by the sum of the separate half-cell reactions shown in equations 1 and 2. Water and heat are typical byproducts of the reaction.

In practice, fuel cells are not operated as single units. Rather, fuel cells are connected in series, either stacked one on top of the other or placed side by side. The series of fuel cells, referred to as a fuel cell stack, is normally enclosed in a housing. The fuel and oxidant are directed through manifolds in the housing to the electrodes. The fuel cell is cooled by either the reactants or a cooling medium. The fuel cell stack also comprises current collectors, cell-to-cell seals and insulation while the required piping and instrumentation are provided external to the fuel cell stack. The fuel cell stack, housing and associated hardware constitute a fuel cell module.

Various parameters have to be monitored to ensure proper fuel cell stack operation. One of these parameters is the voltage across each fuel cell in the fuel cell stack hereinafter referred to as cell voltage. Therefore, differential voltage measurement is required at the two terminals (i.e. anode and cathode) of each fuel cell in the fuel cell stack. However, since fuel cells are connected in series, and typically in large number, the voltages at some terminals will be too high for any currently available semiconductor measuring device to directly measure. For example, for a fuel cell stack consisting of 100 cells with each cell voltage at 0.95 V, the actual voltage on the negative terminal (cathode) of the top cell will be 94.05 V (i.e. 0.95*100-0.95). As such, the voltage exceeds the maximum allowable input voltage of current differential amplifiers commonly used for measuring voltage.

Various efforts have been made to overcome this problem. One method for monitoring high cell voltages is disclosed by Becker-Irvin (US Patent No. 5,914,606) who teaches monitoring cell voltage with the aid of voltage dividers. The voltage dividers are connected to measurement points on a stack of cells. The voltage dividers reduce the voltage at each measurement point so that each voltage is low enough to be an input to a conventional differential amplifier. When the voltage dividers are "closely matched", the output of the differential amplifier is directly proportional to the differential voltage between the pair of points at which the voltage dividers are connected. Hence the differential voltage between those two points can be determined. By selecting the "ratio" of each voltage divider, the system can be used to measure differential voltages in the presence of different common-mode voltages.

However, there are two problems when the cell voltage is monitored with this system. Firstly, since the cells are connected in series, the voltage of the cells near the top of the series connection (i.e. furthest away from the reference potential) must be divided down (i.e. reduced) using extremely high-ratio voltage dividers in order to provide voltages that can be read by the same voltage-measuring circuit which measures the cell voltages of the cells near the bottom of the series connection. Thus, monitoring high voltages requires very high precision resistors in the high-ratio voltage dividers in order to reduce the voltages on each terminal of the cell being measured by the same amount. Secondly, any deviation in the resistance of the resistors in the voltage dividers will cause an impedance mismatch in the Thevenin equivalent of the voltage dividers which will affect the ability of the differential amplifier to properly measure the cell voltage. Therefore, great care must be taken to precisely match the resistances of the resistors used in the voltage dividers. This results in a voltage measurement system with increased cost and decreased efficiency.

Another system for monitoring high voltages was disclosed by Flohr et al. (US Patent No. 5,712,568). Flohr teaches the use of an optical isolation technique to separate the voltage measurement process. Unfortunately, this method is both costly and difficult to implement. James (US Patent No. 6,140,820) also disclosed a voltage monitoring system that used isolation methods incorporating a multiplexer and differential inputs. However, this voltage monitoring system also suffers from impedance mismatch and reduced accuracy.

Patent Abstract of Japan vol. 2000 no. 6, 22 September 2000 & JP 2000 092732 A (Denso Corp) discloses a system for balancing cells of a battery pack by determining the state of charge (SOC) and the open-circuit voltage (OCV) of each cell. Any cell that has a large scattering of the SOC is then discharged automatically by the system using switches.

As can be seen, the above methods do not provide a simple and cost-efficient system for monitoring cell voltage. This is unfortunate since, in the field of fuel cell technology, as fuel cell stacks become larger and more complex, there is an increasing need for simple and accurate cell voltage measurement systems. For instance, it is currently technically difficult to achieve an accurate cell voltage measurement at a reasonable cost for any fuel cell stack that exceeds 40 fuel cells.

## SUMMARY OF THE INVENTION

In order to overcome the problems associated with the current methods of measuring cell voltage, the present invention provides a novel circuit and method for monitoring the voltage of each fuel cell within a fuel cell stack. The fuel cell voltage monitoring circuit is cost effective and easy to operate.

In accordance with the present invention, there is provided a system for monitoring at least one cell voltage of an electrochemical device, the device having a plurality of cells connected in series, each cell providing two terminals, wherein the system comprises:

a plurality of differential amplifiers, each differential amplifier having two inputs and one output and rejecting a high common-mode voltage, the inputs of at least one of the plurality of differential amplifiers being connected, in use, to two of the terminals for measuring a differential voltage thereof;

a switching network having a plurality of inputs and one output, each of the plurality of inputs of the switching network being connected to the output of one of the differential amplifiers;

an analog to digital converier having an input connected to the output of the switching network and adapted to provide digital values indicative of the differential voltage measured by the at least one of the plurality of differential amplifiers;

a controller connected to the switching network and the analog to digital converter to control the operation of the switching network and the analog to digital converter, and to receive the digital values wherein the system is comprising

a calculating means, connected to the output of one of the analog to digital converter and the controller, comprising means for receiving the digital values and applying a factor to the digital values for removing any common-mode voltage errors therefrom.

Preferably, each differential amplifier has a high common-mode rejection ratio. More preferably, each differential amplifier can reject a common-mode voltage of 200 V.

Alternatively, the calculating means may be a part of the controller. A microprocessor may be preferably used as the controller. The system may further comprise a computer that is connected to the controller.

In another aspect of the invention, the system further includes at least one calibrator connectable to one of said plurality of differential amplifiers for determining the factor. The at least one calibrator is adapted to provide two calibration voltages to the input terminals of one of the differential amplifiers the two calibration voltages being offset from one another by a constant voltage increment, for emulating differential voltage and common-mode voltage at the terminals of one of the plurality of cells. The constant voltage increment may be chosen in the range of 0.5 V to 1 V. More preferably, the constant voltage increment may be 0.75 V.

In another aspect of the invention, there is provided a method for monitoring at least one cell voltage for a plurality of electrochemical cells connected in series, each of the electrochemical cells having two terminals, the method comprising the steps of:

(a) connecting two of the terminals from the plurality of electrochemical cells to the inputs of a differential amplifier, the differential amplifier having two inputs and one output, the two terminals providing first and second voltages having a common-mode voltage;
(b) rejecting the common-mode voltage in the differential amplifier to measure a differential voltage between the two terminals;
(c) converting the differential voltage from an analog to a digital value; and,
(d) applying a factor to the digital value for removing common-mode voltage error from the differential voltage.

More particularly step (a) of the method further includes, providing a plurality of differential amplifiers, each differential amplifier having two inputs and one output, and connecting additional pairs of terminals from the plurality of electrochemical cells to the plurality of differential amplifiers, each of the pairs of terminals being connected to inputs of one of the plurality of differential amplifiers, the additional pairs of terminals each having a common-mode voltage; and, the method further includes effecting steps (b), (c) and (d) for each of said differential amplifiers.

The method further includes connecting the output of the differential amplifiers through a switching network to an analog to digital converter, using the switching network to switch the output of one of the differential amplifiers to the analog to digital converter for analog to digital conversion of the voltage differential at the output of said one differential amplifier. The method also includes providing a controller for controlling the switching network and the analog to digital converter. The method further includes providing the controller as a microprocessor.

The method further includes the step of:

(e) providing known first arid second calibration voltages, from a calibrator, to the inputs of each differential amplifier and measuring the voltage at the output thereof for determining the factor.

The method further includes effecting step (e) for each differential amplifier according to the steps of:

(f) connecting the output of the differential amplifier to an analog to digital converter;
(g) applying a voltage $V_A$, based on the first and second calibration voltages, across the inputs of the differential amplifier and measuring $V_A$;
(h) measuring the analog to digital converter output ($V_{ADC}(V_A)$)) when $V_A$ is applied differentially to the inputs of the differential amplifier;
(i) measuring the analog to digital converter output ($V_{ADC}(V_0)$) when the inputs of the differential amplifier are connected to ground; and,

(i) measuring the DC offset voltage ($V_{OFF}$) at the output of the differential amplifier when the inputs of tne differential amplifier are tied to ground.

The method further includes calculating a calibrated measured cell voltage ($V_R$) for monitoring the at least one cell voltage, the calibrated measured cell voltage ($V_R$) being based on a measured voltage obtained from the analog to digital converter output ($V_{ADC}$) when the inputs of the differential amplifier are connected across two of the terminals, wherein the calculation is carried out according to:

$$V_R = \frac{V_A \bullet V_{ADC}}{\left[ V_{ADC}(V_A) - V_{ADC}(V_0) \right]} - V_{OFF}$$

The method further includes providing differential amplifiers which each have a high common-mode rejection ratio. More preferably, each differential amplifier can reject a common-mode voltage of 200 V.

The method further includes providing the second calibration voltage with a constant voltage increment with respect to the first calibration voltage to emulate the differential voltage and common-mode voltage that would be expected, under normal operating conditions, at the terminals of a cell from the plurality of electrochemical cells. The constant voltage increment may be selected in the range of 0.5 V to 1 V. More preferably, the constant voltage increment may be 0.75 V.

The method further includes monitoring the cell voltage of each cell in the plurality of cells sequentially. Alternatively, the cell voltage of any cell, from the plurality of cells, can be measured at any time. The method further comprises applying the measurement method to fuel cell voltages.

Further objects and advantages of the present invention will appear from the following description, taken together with the accompanying drawings.

## DETAILED DESCRIPTION OF THE DRAWINGS

For a better understanding of the present invention and to show more clearly how it may be carried into effect, reference will now be made, by way of example, to the accompanying drawings which show a preferred embodiment of the present invention and in which:

Figure 1 is a schematic of a pnor art cell voltage monitoring system;
Figure 2 is a schematic of an embodiment of a fuel cell voltage monitoring system in accordance with the present invention;
Figure 3a is a partial view of an example of cell voltage measurement on a fuel cell stack using the fuel cell voltage monitoring system of Figure 2; and,
Figure 3b is a partial view of the calibration required for the fuel cell voltage monitoring system of Figure 2.

## DETAILED DESCRIPTION OF THE PREFERRED EMBODIMENT

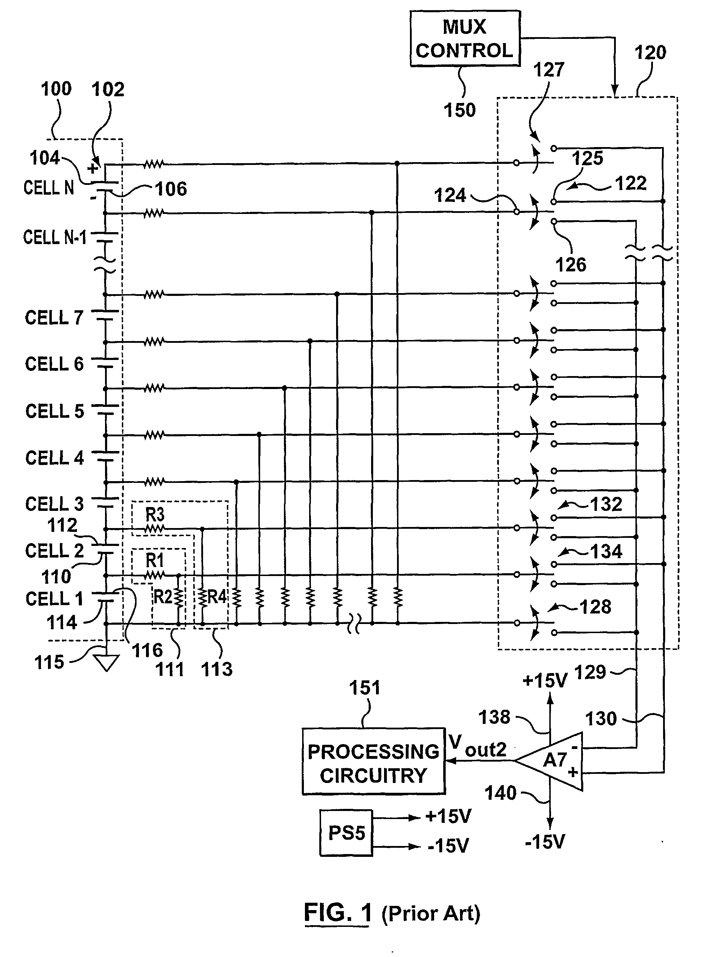

Referring first to Figure 1, the system disclosed by Becker-Irvin (US Patent No. 5,914,606) is shown. Measurement points **114** and **116** are connected to the inputs of a voltage divider **111.** Other measurement points are also connected to respective inputs of other voltage dividers. All the divider outputs are connected to a multiplexer **120** that has outputs **129** and **130.** These outputs are connected to a differential amplifier **A7**. By appropriately closing switches, such as **124** and **127**, the two voltage divider outputs are connected to the multiplexer **120.** When the voltage dividers are "closely matched", the output of the differential amplifier **A7** will be directly proportional to the differential voltage between the pair of points at which the voltage dividers were connected. However, as previously discussed, extremely high precision resistors must be used in the voltage dividers. Further, any deviation in the resistance of these resistors will result in improper cell voltage measurement.

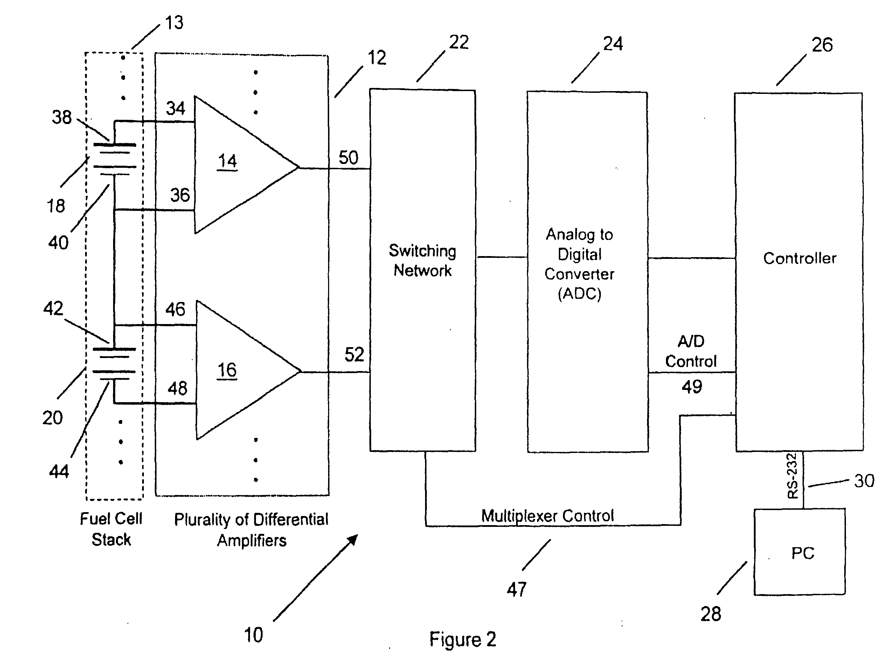

Referring now to Figure 2, in accordance with the present invention, a schematic of a fuel cell voltage monitoring system is indicated at **10.** The fuel cell voltage monitoring system **10** comprises a plurality of differential amplifiers **12** which are connected to a fuel cell stack **13.** For simplicity, only two differential amplifiers **14** and **16** and two fuel cells **18** and **20** are shown. The fuel cell voltage monitoring system **10** further comprises a switching network **22**, an analog to digital converter (ADC) **24,** a controller **26** and a PC **28.** The fuel cell voltage monitoring system **10** further comprises a calculating means which may be contained within the controller **26.** Alternatively, the calculating means may be connected to the output of the controller **26** or the calculating means may be connected to the output of the analog to digital controller **24** The inputs of the plurality of differential amplifiers **12** are connected to the terminals of the fuel cells in the fuel cell stack **13** and the outputs of the plurality of differential amplifiers **12** are connected to the switching network **22.** The switching network **22** is also connected to the ADC **24.** The ADC **24** is connected to the controller **26** which is in turn connected to the PC **28** via an RS 232 cable **30** or any other commercially available PC communication link. The calculation means applies a factor to the digital values read from the ADC **24** for providing for more accurate monitoring of the measured cell voltages. The factor is described in more detail further below.

To effect cell voltage measurement, a plurality of differential amplifiers **12** are used wherein each differential amplifier has a high common-mode rejection ratio. Each differential amplifier preferably is also highly linear Each amplifier may have a gain of substantially unity. Each amplifier should also be able to reject as high a voltage as possible at each input. However, the input differential is limited by the power supply voltage as is commonly known in the art. Accordingly, the input differential may be limited to a range of +/- 15 V.

In Figure 2, each differential amplifier, from the plurality of differential amplifiers **12,** is connected to the terminals of a respective fuel cell, in the fuel cell stack **13,** whose cell voltage is to be measured. For instance, in Figure 2, differential amplifier **14** is connected across fuel cell **18.** In particular, the two inputs **34** and **36** of the differential amplifier **14** are connected to the anode **38** and the cathode **40** of the fuel cell **18.** Alternatively, in practice, the inputs of a differential amplifier, chosen from the plurality of differential amplifiers **12,** do not necessarily have to be connected to the two terminals of one fuel cell. Rather the inputs of the differential amplifier may be connected to any two terminals on the fuel cell stack **13** as desired. For instance, for differential amplifier **14,** the input **34** may be connected to the terminal **38** of fuel cell **18** and the input **36** may be connected to the terminal **44** of fuel cell 20. In this description, for simplicity, each differential amplifier is assumed to be connected to the terminals of a unique fuel cell.

In the fuel cell voltage monitoring system **10,** the output of each differential amplifier, from the plurality of differential amplifiers **12,** is then connected to the inputs of the switching network 22. Accordingly, in Figure 2, the output **50** of the differential amplifier **14** and the output **52** of the differential amplifier **16** are connected to the inputs of the switching network **22** (only two inputs are shown for simplicity). Preferably, the switching network **22** may be a multiplexer or the like. The switching network **22** only allows the differential voltage measured at two points on the fuel cell stack **13** to be accessed at any one time. This configuration is desirable for reducing the number of components in the fuel cell voltage monitoring system **10**. The cell voltages may also be monitored at a high speed so that measuring only one cell voltage at a time is acceptable. The differential voltage measured at the two terminals on the fuel cell stack **13** are then sent from the switching network **22** to the ADC **24.**

The ADC **24** converts the measured analog voltages to digital values. In practice, the ADC **24** may be a 16-bit ADC. Alternatively, an ADC with more bits may be used to obtain more accurate digital values. After the analog to digital conversion, the digital values are sent to the controller **26**.

The controller **26** controls the function of the fuel cell voltage monitoring system **10**. In particular, the controller **26** controls the operation of the switching network **22** via a switching network control signal **47** and the ADC **24** via an ADC control signal **49**. The controller **26** controls the switching network **22** to selectively receive the digital values for the cell voltage measured at the two terminals of a specific fuel cell in the fuel cell stack **13**. Preferably, the controller **26** directs the switching network **22** to access the voltage measured across each fuel cell in the fuel cell stack **13** in sequential order and reads the corresponding digital values from the ADC **24.** Alternatively, the measured voltage across any fuel cell can be accessed at any time by appropriately programming the controller **26**. The controller is preferably a microprocessor but may also be another control device such as a PLC or the like.

As mentioned previously, the controller **26** may include the calculating means **27** for converting the digital values read from the ADC **24** into a measured cell voltage (further explained below). Preferably, the controller **26** is further connected to a PC **28** via an RS232 cable **30** or the like which can be used to provide enhanced data processing to monitor fuel cell performance. The cell voltages allow a user to assess the overall condition of an individual fuel cell. The cell voltages can be used to determine if there is water accumulation in a cell, or if gases are mixing, etc. How often cell voltages are measured is also important. Cell voltage measurement must be sufficiently fast to report brief, transient conditions on the cells. It is preferred to perform a measurement every 10 ms on every cell, which has been shown to be more than sufficient. Note that PC **28** may be in a remote location.

The plurality of differential amplifiers **12** used in the fuel cell voltage monitoring system **10** may be chosen from any commercially available differential amplifier having a high common-mode rejection ratio. Examples include the Burr-Brown INA 117 differential amplifier or the Analog Devices AD629 differential amplifier. These differential amplifiers can function with a common-mode voltage of up to 200 V and can therefore be connected directly to the cathode and anode of a fuel cell from the fuel cell stack **13** as shown in Figure 2.

In practice, the fuel cell voltage monitoring system **10** requires calibration in order to obtain accurate voltage measurements. As is well known to those skilled in the art, when the number of individual fuel cells in the fuel cell stack **13** increases, the voltages at the two terminals of a single fuel cell increases. This increase is larger the further away the single fuel cell is from the reference potential of the fuel cell stack **13**. Accordingly, the common-mode voltage of the inputs of the differential amplifier connected to the single fuel cell also increases (the common-mode voltage is simply the average value of the inputs). The common-mode voltage of the inputs to the differential amplifier results in a voltage at the output of the differential amplifier which will corrupt the voltage measurement of the differential amplifier. This common-mode voltage error is equal to the product of the common-mode voltage gain of the differential amplifier and the common-mode voltage of the inputs. Thus, the common-mode voltage error is proportional to the common-mode voltage of the inputs of the differential amplifier. Accordingly, the differential amplifier preferably has a high common-mode rejection ratio (CMRR) which is the ratio of the input voltage when the inputs are tied together divided by the output voltage. The CMRR is usually expressed in dB (i.e. CMRR (dB) = 20 log (input voltage/output voltage)). Typically, values for CMRR are approximately in the range of 70 to 110 dB. An amplifier with a high common-mode rejection ratio, by definition, has a small common-mode voltage gain.

In addition, due to unavoidable internal mismatches in the differential amplifier, an extraneous voltage occurs at the output of the differential amplifier. This output voltage is referred to as the DC offset of the differential amplifier. The DC offset is observed as a finite voltage at the output of the differential amplifier when the inputs of the differential amplifier are connected to ground.

Furthermore, a voltage error can result in the measurement due to the quantization noise of the ADC **24**. However, as is well known in the art, the quantization noise can be reduced to an acceptable level by increasing the number of quantization bits in the ADC **24.**

Due to the common-mode voltage error, the DC offset and to some extent the quantization noise, the output of the differential amplifier will deviate from the actual cell voltage of the fuel cell. This deviation is referred to as a residual voltage which is a measurement error that cannot be eliminated with common differential amplifier arrangements. As discussed previously, the residual voltage is proportional to the common-mode voltage of the inputs of the differential amplifier. This is not desirable since as the total number of individual fuel cells increase, the common-mode voltage of the inputs of the differential amplifier increase. Therefore, the deviation in the measured cell voltage for those fuel cells at the top of the fuel cell stack **13** will be large enough to significantly affect the accuracy of the cell voltage measurement.

The above problem can be overcome if the measured cell voltage of the fuel cell is calculated based on a linear equation which uses the digital values obtained from the voltage measurement of each fuel cell. In order to perform the calculation, at least one voltmeter and at least one calibrator are needed for reading voltage values during a calibration process. Preferably, the voltmeter is a high precision voltmeter.

The cell voltage for each fuel cell, measured by a given differential amplifier, can be calculated using the following equation:

$$V_R = \frac{V_A \bullet V_{ADC}}{\left[V_{ADC}(V_A) - V_{ADC}(V_0)\right]} - V_{OFF} \qquad (3)$$

where: $V_R$ is the calibrated measured cell voltage

$V_{ADC}$ is the output value of the ADC **24** during the cell voltage measurement

$V_A$ is the voltage applied differentially to the input of the differential amplifier during calibration

$V_{ADC}(V_A)$ is the output value of the ADC **24** when $V_A$ is applied to the inputs of the differential amplifier during calibration

$V_{ADC}(V_0)$ is the output value of the ADC **24** when the inputs of the differential amplifier are tied to ground during calibration

$V_{OFF}$ is the voltage output of the differential amplifier when the inputs of the differential amplifier are tied to ground during calibration

Equation 3 removes the measurement errors to obtain the measured cell voltage for the fuel cell being measured. The voltage $V_{OFF}$ represents the DC offset and common mode voltage errors. These errors are removed from the measured value since, based on the principle of superposition, the measured voltage will be the addition of the cell voltage plus these errors. Secondly, the factor $V_{ADC}/[V_{ADC}(V_A) - V_{ADC}(V_0)]$ is used to correlate the output of the ADC **24** to a meaningful value in Volts.

This calculation may be carried out by the controller **26.** Alternatively, another processing device may be used. The calibrated data may then be read by the PC **28** for recording and analysis. By controlling the switching network **22** to access each differential amplifier from the plurality of differential amplifiers **12** in sequence, the cell voltage for each fuel cell in the fuel cell stack **13** can be obtained.

Figure 3a illustrates the measurement error which occurs when measuring the cell voltage of a fuel cell, from the fuel cell stack **13,** if calibration is not used. Assuming there are 102 fuel cells in the fuel cell stack **13** and that each fuel cell operates at 0.75 V (i.e. the cell voltage is 0.75 V), the actual common-mode voltage of the 102nd fuel cell is 75.75 V (i.e. 0.75*101) as shown in Figure 3a. If a residual voltage error of +50 mV occurs at the output of the differential amplifier **66** connected to the 102nd fuel cell, the output of the differential amplifier **66** will be 0.8 V (i.e. 0.75+0.05) instead of 0.75 V and it has unity gain. Typically it is expected that voltages can vary in the range up to 5 Volts.

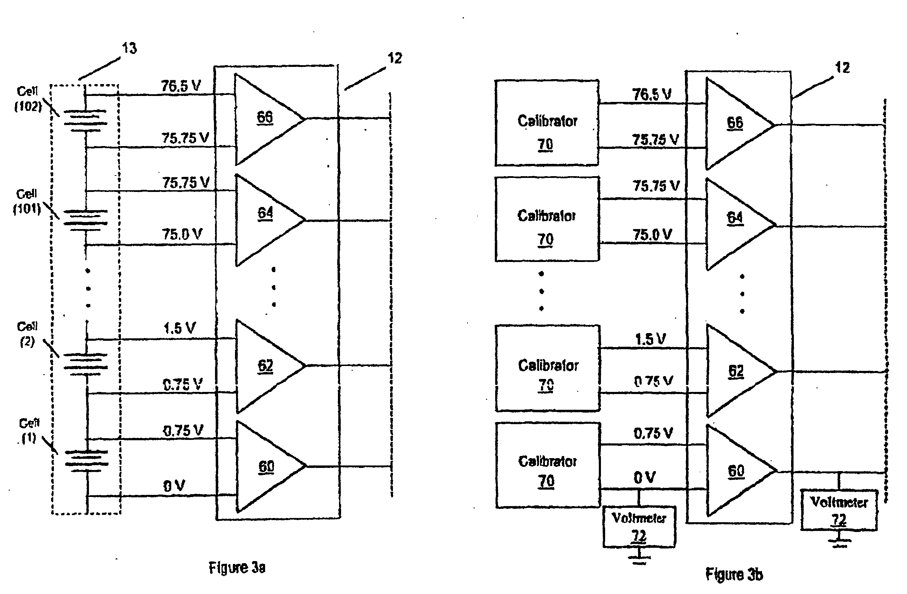

Referring now to Figure 3b, the measurement error can be eliminated by calibrating the differential amplifier **66** with a calibrator **70** that provides the exact common-mode voltage and cell voltage that would be expected for the 102nd fuel cell which in this example are 75.75 V and 0.75 V respectively. A calibrator may be provided for each differential amplifier of the plurality of differential amplifiers **12**. Alternatively, one calibrator may be re-used for each differential amplifier from the plurality of differential amplifiers **12**. Figure 3b also shows two exemplary placements of a voltmeter **72** for taking accurate voltage measurements at various nodes of the fuel cell voltage monitoring system **10** during calibration with the calibrator **70**. When the calibrator **70** is employed to calibrate the differential amplifier **66**, the common-mode voltage error and the DC offset of the differential amplifier will be obtained. However, during measurement, the output of the differential amplifier **66** will be the same as it was before calibration was performed (i.e. 0.80 V in the example). Thus, equation **3** must be used to obtain the actual cell voltage and significantly reduce the residual error.

Although it is difficult to Know the actual cell voltage of each fuel cell, it is known that individual fuel cells operate between approximately 0.5 V to 1.0 V during normal operation. By applying a calibrator that provides voltage levels close to these cell voltages, the plurality of differential amplifiers **12** may be calibrated before they are used to measure the cell voltages of fuel cells in the fuel cell stack **13**. Therefore, the common-mode voltage error and the DC offset of each differential amplifier can be obtained. Consequently, by calibrating each differential amplifier, the accuracy of the fuel cell voltage monitoring system **10** considerably increases.

Since individual fuel cells operate in the range of 0.5 V to 1.0 V, each fuel cell may be assumed to have a cell voltage of 0.75 V. This is an average voltage at which fuel cells operate during normal use. Therefore, during calibration an increment of 0.75 V is used which means the calibrator provides voltages as if the upper terminal of fuel cell 1 is at 0.75 V, the upper terminal of fuel cell 2 is at 1.5 V, the upper terminal of fuel cell 3 is at 2.25 V and the upper terminal of fuel cell 101 is at 76.5 V, as shown in Figure 3b. The inventor has found that by using this method in practice, each differential amplifier was calibrated at a common-mode voltage which was close to the actual common-mode voltage at the cell terminals of each fuel cell when each fuel cell was operating under ideal conditions. As a result, the measured cell voltages were close to the actual cell voltage of each fuel cell.

Although the calibration method does not completely eliminate the residual error, it significantly reduces the residual error and most notably the common-mode voltage error. Further, after calibration, the common-mode voltage error occurring during the voltage measurement of a given differential amplifier is no longer proportional to the common-mode voltage at the inputs of the differential amplifier. The common-mode voltage error is now proportional to the difference between the actual common-mode voltage at the inputs and the assumed common-mode voltage that was used for each fuel cell during calibration. This difference is random and does not increase as the number of fuel cells in the fuel cell stack **13** increase. Therefore, the common-mode voltage error is maintained at a very low level during cell voltage measurement. This is particularly advantageous when measuring the cell voltage of fuel cells in a large fuel cell stack.

The fuel cell voltage monitoring system **10** according to the present invention uses commonly available components which are inexpensive and do not require any hardware adjustments. The present invention also provides for a simple to use and highly precise measurement system. Furthermore, compared to existing cell voltage monitoring systems, the present invention has fewer components which significantly reduces the overall size of the system. Therefore, the fuel cell voltage monitoring system **10** can be easily incorporated into any fuel cell testing device.

It should be appreciated that the present invention is intended not only for monitoring the voltages of individual fuel cells, in fuel cell stacks, but also for monitoring the voltages in any kind of multi-cell battery formed by connecting individual cells in series. The present invention can also be used to monitor the voltage of a single cell, a battery, a battery bank or an electrolyser.

It should be further understood that various modifications can be made, by those skilled in the art, to the preferred embodiments described and illustrated herein, without departing from the present invention, the scope of which is defined in the appended claims.

## Claims

1. A system (10) for monitoring at least one cell voltage of an electrochemical device, the device having a plurality of cells (18, 20) connected in series, each cell providing two terminals, the system comprising:

    a plurality of differential amplifiers (12), each differential amplifier (14, 16) having two inputs (34, 36, 46, 48) and one output (50, 52) wherein each output (50, 52) of the plurality of differential amplifiers (12) rejects a high common-mode voltage, the inputs of at least one of the plurality of differential amplifiers (12) being connected, in use, to two of the terminals for measuring a differential voltage thereof,
    a switching network (22) having a plurality of inputs and one output,
    an analog to digital converter (24) having an input connected to the output of the switching network (22), and wherein each of the plurality of inputs of the switching network (22) is connected to the output (50, 52) of one of the differential amplifiers (14, 16), the analog to digital converter (24) being adapted to provide digital values indicative of the differential voltage measured by the at least one of the plurality of differential amplifiers (12),
    a controller (26) connected to the switching network (22) and the analog to digital converter (24) to control the operation of the switching network (22) and the analog to digital converter (24), and to receive the digital values, the system being **characterized by**:
    a calculating means, connected to the output of one of the analog to digital converter (24) and the controller (26) comprising means for receiving the digital values and applying a factor to the digital values for removing any common-mode voltage errors there-from.

2. A system (10) as claimed in claim 1, **characterized in that** each differential amplifier (14, 16) is adapted to reject a common-mode voltage of 200 V.

3. A system (10) as claimed in claim 1, **characterized in that** the controller (26) provides the calculating means.

4. A system (10) as claimed in claim 1, **characterized in that** the controller (26) comprises a microprocessor.

5. A system (10) as claimed in claim 1, **characterized in that** the system (10) further comprises a computer (28) and the controller (26) is connected to the computer (28).

**6.** A system (10) as claimed in claim 1, **characterized in that** the calculating means applies a linear equation for removing errors from the digital values, the linear equation being defined by calibration for at least two input voltages.

**7.** A system (10) as claimed in claim 6, **characterized in that** the system (10) further comprises at least one calibrator (70) connectable to one of the plurality of differential amplifiers (12) for determining the factor.

**8.** A system (10) as claimed in claim 7, **characterized in that** the at least one calibrator is adapted to provide two calibration voltages to the inputs (50, 52) of the one of the plurality of differential amplifiers (12), the two calibration voltages being offset from one another by a constant voltage increment for emulating differential voltage and common-mode voltage at the terminals of one of the plurality of cells (18, 20).

**9.** A system (10) as claimed in claim 8, **characterized in that** the constant voltage increment is chosen in the range of 0.5 V to 1 V.

**10.** A system (10) as claimed in claim 9, **characterized in that** the constant voltage increment is 0.75 V.

**11.** A system (10) as claimed in claim 8, **characterized in that** the calculating means applies the factor to the digital values sampled from voltage values measured by a selected differential amplifier (14, 16) from the plurality of differential amplifiers (12) according to:

$$V_R = \frac{V_A \bullet V_{ADC}}{\left[V_{ADC}(V_A) - V_{ADC}(V_0)\right]} - V_{OFF}$$

where $V_A$ is a voltage, based on the first and second calibration voltages, that is applied across the inputs of the selected differential amplifier (14, 16), $V_{ADC}(V_A)$ is the voltage measured at the analog to digital converter (24) output when $V_A$ is applied differentially to the inputs (50, 52) of the selected differential amplifier (14, 16), $V_{ADC}(V_0)$ is the voltage measured at the analog to digital converter (24) output when the inputs (34, 36, 46, 48) of the selected differential amplifier (14, 16) are connected to ground, $V_{OFF}$ is the DC offset voltage measured at the output of the given differential amplifier (14, 16) when the inputs (34, 36, 46, 48) of the differential amplifier (14, 16) are tied to ground, and $V_{ADC}$ represents the digital values from which the common mode voltage errors are removed.

**12.** A method for monitoring at least one cell voltage for a plurality of electrochemical cells (18, 20) connected in series, each of the electrochemical cells (18, 20) having two terminals, the method comprising the steps of:

(a) connecting two of the terminals from the plurality of electrochemical cells (18, 20) to the inputs (34, 36, 46, 48) of a differential amplifier (14, 16), the differential amplifier (14, 16) having two inputs (34, 36, 46, 48) and one output (50, 52), the two terminals providing first and second voltages having a common-mode voltage;
(b) rejecting the common-mode voltage in the differential amplifier (14, 16) to measure a differential voltage between the two terminals;
(c) converting the differential voltage from an analog to a digital value; and **characterised by**
(d) applying a factor to the digital value for removing common-mode voltage error from the differential voltage.

**13.** A method as claimed in claim 12, **characterized in that** step (a) further includes providing a plurality of differential amplifiers (12), each differential amplifier (14, 16) having two inputs (34, 36, 46, 48) and one output (50, 52), and connecting additional pairs of terminals from the plurality of electrochemical cells (18, 20) to the plurality of differential amplifiers (12), each of the pairs of terminals being connected to inputs (34, 36, 46, 48) of one of the plurality of differential amplifiers (14, 16), the additional pairs of terminals each having a common-mode voltage; and effecting steps (b), (c) and (d) for each of the differential amplifiers (14, 16).

**14.** A method as claimed in claim 13, **characterized in that** the method further includes connecting the outputs (50, 52) of the differential amplifiers (14, 16) through a switching network (22) to an analog to digital converter (24), using the switching network (22) to switch the output (50, 52) of one of the differential amplifiers (14, 16) to the analog to digital converter (24) for analog to digital conversion of the differential voltage at the output of the one differential amplifier (14, 16).

**15.** A method as claimed in claim 14, **characterized in that** the method further includes providing a controller (26) for controlling the switching network (22) and the analog to digital converter (24).

**16.** A method as claimed in claim 15, **characterized in that** the method further includes providing the controller (26) as a microprocessor.

**17.** A method as claimed in claim 12, **characterized in that** step (d) comprises applying a linear equation for removing errors from the digital value, the linear equation being defined by calibration for at least two input voltages.

**18.** A method as claimed in claim 12 or 13, **characterized in that** the method further includes the step of:

(e) providing known first and second calibration voltages, from a calibrator, to the inputs of each differential amplifier (14, 16) and measuring the voltage at the output thereof (50, 52) for determining the factor.

**19.** A method as claimed in claim 18, **characterized in that** the method includes effecting step (e) for each differential amplifier (14, 16) according to the steps of:

(f) connecting the output (50, 52) of the differential amplifier (14, 16) to an analog to digital converter;
(g) applying a voltage $V_A$, based on the first and second calibration voltages, across the inputs (34, 36, 46, 48) of the differential amplifier (14, 16) and measuring $V_A$;
(h) measuring the analog to digital converter (24) output ($V_{ADC}(V_A)$)) when $V_A$ is applied differentially to the inputs of the differential amplifier (14, 16);
(i) measuring the analog to digital converter (24) output ($V_{ADC}(V_0)$) when the inputs (34, 36, 46, 48) of the differential amplifier (14, 16) are connected to ground; and,
(j) measuring the DC offset voltage ($V_{OFF}$) at the output (50, 52) of the differential amplifier (14, 16) when the inputs (34, 36, 46, 48) of the differential amplifier (14, 16) are tied to ground.

**20.** A method as claimed in claim 19, **characterized in that** the method further includes calculating a calibrated measured cell voltage ($V_R$) for monitoring the at least one cell voltage, the calibrated measured cell voltage ($V_R$) being based on a measured voltage obtained from the analog to digital converter (24) output ($V_{ADC}$) when the inputs (34, 36, 46, 48) of the differential amplifier (14, 16) are connected across two of the terminals, wherein the calculation is carried out according to:

$$V_R = \frac{V_A \bullet V_{ADC}}{\left[ V_{ADC}\!\left(V_A\right) - V_{ADC}\!\left(V_0\right) \right]} - V_{OFF}$$

**21.** A method as claimed in claim 13, **characterized in that** the method further includes providing differential amplifiers (14, 16) which can reject a common-mode voltage of 200 V.

**22.** A method as claimed in claim 18, **characterized in that** the method further includes providing the second calibration voltage with a constant voltage increment with respect to the first calibration voltage to emulate the differential voltage and common-mode voltage that would be expected, under normal operating conditions, at the terminals of a cell from the plurality of electrochemical cells (18, 20).

**23.** A method as claimed in claim 21, **characterized in that** the method further includes selecting the constant voltage increment in the range of 0.5 V to 1 V.

**24.** A method as claimed in claim 23, **characterized in that** the method further includes selecting the constant voltage increment to be 0.75 V.

**25.** A method as claimed in claim 12, **characterized in that** the method further includes monitoring the cell voltage of each of the electrochemical cells (18, 20) sequentially.

**26.** A method as claimed in claim 12, **characterized in that** the method further includes monitoring the cell voltage of any of the electrochemical cells (18, 20) at any time.

**27.** A method as claimed in claim 12, **characterized in that** the method further comprises applying the method to measurement of fuel cell voltages.

**Patentansprüche**

**1.** System (10) zum Überwachen von wenigstens einer Zellspannung einer elektrochemischen Vorrichtung, wobei die Vorrichtung eine Mehrzahl von Zellen (8, 20) aufweist, die in Reihe verbunden sind, wobei jede Zelle zwei Anschlüsse bereitstellt,
wobei das System umfasst:

eine Mehrzahl von Differentialverstärkern (12), wobei jeder Differentialverstärker (14, 16) zwei Eingänge (34, 36, 46, 48) und einen Ausgang (50, 52) aufweist, wobei jeder Ausgang (50, 52) der Mehrzahl von Differentialverstärkern (12) eine Gleichtakthochspannung sperrt, wobei die Eingänge von wenigstens einem der Mehrzahl von Differentialverstärkern (12) bei Verwendung mit zwei der Anschlüsse zum Messen einer Differenzspannung desselben verbunden sind,
ein Schaltnetzwerk (22), das eine Mehrzahl von Eingängen und einen Ausgang aufweist,
einen Analog-Digital-Wandler (24), der einen Eingang aufweist, der mit dem Ausgang des Schaltnetzwerks (22) verbunden ist,
und wobei jeder der Mehrzahl von Eingängen des Schaltnetzwerks (22) mit dem Ausgang (50, 52) von einem der Differentialverstärker (14, 16) verbunden ist, der Analog-Digital-Wandler (24) ausgelegt ist, digitale Werte bereitzustellen, die die Differenzspannung angeben, die durch den wenigstens einen der Mehrzahl von Differentialverstärkern (12) gemessen wird,
eine Steuereinrichtung (26), die mit dem Schaltnetzwerk (22) und dem Analog-Digital-Wandler (24) verbunden ist, um den Betrieb des Schaltnetzwerks (22) und des Analog-Digital-Wandlers (24) zu steuern und um die digitalen Werte zu empfangen, wobei das System **gekennzeichnet ist durch**:

eine Berechnungseinrichtung, die mit dem Ausgang von entweder dem Analog-Digital-Wandler (24) oder der Steuereinrichtung (26) verbunden ist, die eine Einrichtung zum Empfangen der digitalen Werte und zum Anwenden eines Faktors auf die digitalen Werte umfasst, um Gleichtaktspannungsfehler von diesen zu entfernen.

**2.** System (10) nach Anspruch 1, **dadurch gekennzeichnet, dass** jeder Differentialverstärker (14, 16) ausgelegt ist, eine Gleichtaktspannung von 200 V zu sperren.

**3.** System (10) nach Anspruch 1, **dadurch gekennzeichnet, dass** die Steuereinrichtung (26) die Berechnungseinrichtung bereitstellt.

**4.** System (10) nach Anspruch 1, **dadurch gekennzeichnet, dass** die Steuereinrichtung (26) einen Mikroprozessor umfasst.

**5.** System (10) nach Anspruch 1, **dadurch gekennzeichnet, dass** das System (10) ferner einen Computer (28) umfasst und die Steuereinrichtung (26) mit dem Computer (28) verbunden ist.

**6.** System (10) nach Anspruch 1, **dadurch gekennzeichnet, dass** die Berechnungseinrichtung eine lineare Gleichung anwendet, um Fehler aus den digitalen Werten zu entfernen, wobei die lineare Gleichung durch eine Kalibrierung von wenigstens zwei Eingangsspannungen definiert ist.

**7.** System (10) nach Anspruch 6, **dadurch gekennzeichnet, dass** das System (10) wenigstens eine Kalibriereinrichtung (70) umfasst, die mit einem der Mehrzahl von Differentialverstärkern (12) verbindbar ist, um den Faktor zu ermitteln.

**8.** System (10) nach Anspruch 7, **dadurch gekennzeichnet, dass** die wenigstens eine Kalibriereinrichtung ausgelegt ist, zwei Kalibrierspannungen den Eingängen (50, 52) des einen der Mehrzahl von Differentialverstärkern (12) bereit zu stellen, wobei die zwei Kalibrierspannungen um ein konstantes Spannungsinkrement voneinander versetzt sind, um eine Differenzspannung und eine Gleichtaktspannung an den Anschlüssen von einer der Mehrzahl von Zellen (18, 20) zu emulieren.

9. System (10) nach Anspruch 8, **dadurch gekennzeichnet, dass** das konstante Spannungsinkrement in dem Bereich von 0,5 V bis 1 V gewählt ist.

10. System (10) nach Anspruch 9, **dadurch gekennzeichnet, dass** das konstante Spannungsinkrement 0,75 V beträgt.

11. System (10) nach Anspruch 8, **dadurch gekennzeichnet, dass** die Berechnungseinrichtung den Faktor auf die digitalen Werte anwendet, die aus den Spannungswerten abgetastet werden, die von einem ausgewählten Differentialverstärkern (14, 16) unter der Mehrzahl von Differentialverstärkern (12) gemessen werden, gemäß

$$V_R = \frac{V_A \bullet V_{ADC}}{[V_{ADC}(V_A) - V_{ADC}(V_0)]} - V_{OFF}$$

wobei $V_a$ eine auf den ersten und zweiten Kalibierspannungen basierende Spannung ist, die über den Eingängen des ausgewählten Differentialverstärkers (14, 16) angelegt wird, $V_{ADC}$ ($V_A$) die Spannung ist, die an dem Ausgang des Analog-Digital-Wandlers (24) gemessen wird, wenn $V_A$ an die Eingänge (50, 52) des ausgewählten Differentialverstärkers (14, 16) differentiell angelegt wird, $V_{ADC}$ ($V_0$) die Spannung ist, die an dem Ausgang des Analog-Digital-Wandlers (24) gemessen wird, wenn die Eingänge (34, 36, 46, 48) des ausgewählten Differentialverstärkers (14, 16) mit Masse verbunden sind, $V_{OFF}$ die Offset-Gleichspannung ist, die an dem Ausgang des ausgewählten Differentialverstärkers (14, 16) gemessen wird, wenn die Eingänge (34, 36, 46, 48) des Differentialverstärkers (14, 16) auf Masse gelegt werden, und $V_{ADC}$ die digitalen Werte angibt, von denen die Gleichtaktspannungsfehler entfernt werden.

12. Verfahren zum Überwachen wenigstens einer Zellspannung für eine Mehrzahl von elektrochemischen Zellen (18, 20), die in Reihe verbunden sind, wobei die elektrochemischen Zellen (18, 20) zwei Anschlüsse aufweisen, wobei das Verfahren die Schritte umfasst:

(a) Verbinden von zwei der Anschlüsse der Mehrzahl von elektrochemischen Zellen (18, 20) mit den Eingängen (34, 36, 46, 48) eines Differentialverstärkers (14, 16), wobei der Differentialverstärker (14, 16) zwei Eingänge (34, 36, 46, 48) und einen Ausgang (50, 52) aufweist, wobei die zwei Anschlüsse eine erste und eine zweite Spannung bereitstellen, die eine Gleichtaktspannung aufweisen,
(b) Sperren der Gleichtaktspannung in dem Differentialverstärker (14, 16), um eine Differenzspannung zwischen den zwei Anschlüssen zu messen,
(c) Umwandeln der Differenzspannung von einem analogen in einen digitalen Wert, und **gekennzeichnet durch** den Schritt:
(d) Anwenden eines Faktors auf den digitalen Wert, um einen Gleichtaktspannungsfehler aus der Differenzspannung zu entfernen.

13. Verfahren nach Anspruch 12, **dadurch gekennzeichnet, dass** der Schritt (a) ferner umfasst, eine Mehrzahl von Differentialverstärkern (12) bereitzustellen, wobei jeder Differentialverstärker (14, 16) zwei Eingänge (34, 36, 46, 48) und einen Ausgang (50, 52) aufweist, und zusätzliche Paare von Anschlüssen der Mehrzahl von elektrochemischen Zellen (18, 20) mit der Mehrzahl von Differentialverstärkern (12) zu verbinden, wobei jedes der Paare von Anschlüssen mit Eingängen (34, 36, 46, 48) von einem der Mehrzahl der Differentialverstärker (14, 16) verbunden ist, wobei die zusätzlichen Paare von Anschlüssen jeweils eine Gleichtaktspannung aufweisen, und die Schritte (b), (c) und (d) für jeden der Differentialverstärker (14, 16) durchgeführt werden.

14. Verfahren nach Anspruch 13, **dadurch gekennzeichnet, dass** das Verfahren ferner umfasst, die Ausgänge (50, 52) der Differentialverstärker (14, 16) über ein Schaltnetzwerk (22) mit einem Analog-Digital-Wandler (24) zu verbinden, wobei das Schaltnetzwerk (22) verwendet wird, um den Ausgang (50, 52) von einem der Differentialverstärker (14, 16) zu dem Analog-Digital-Wandler (24) für eine Analog-Digital-Wandlung der Differenzspannung an dem Ausgang des einen Differentialverstärkers (14, 16) zu schalten.

15. Verfahren nach Anspruch 14, **dadurch gekennzeichnet, dass** das Verfahren ferner umfasst, eine Steuereinrichtung (26) bereitzustellen, um das Schaltnetzwerk (22) und den Analog-Digital-Wandler (24) zu steuern.

**16.** Verfahren nach Anspruch 15, **dadurch gekennzeichnet, dass** das Verfahren ferner umfasst, die Steuereinrichtung (26) als Mikroprozessor bereitzustellen.

**17.** Verfahren nach Anspruch 12, **dadurch gekennzeichnet, dass** Schritt (d) umfasst, eine lineare Gleichung zum Entfernen von Fehlern aus den digitalen Werten anzuwenden, wobei die lineare Gleichung durch eine Kalibrierung von wenigstens zwei Eingangsspannungen definiert wird.

**18.** Verfahren nach Anspruch 12 oder 13, **dadurch gekennzeichnet, dass** das Verfahren ferner den Schritt umfasst:

(e) bekannte erste und zweite Kalibrierspannungen von einer Kalibriereinrichtung den Eingängen jedes Differentialverstärkers (14, 16) bereitzustellen und die Spannung an dem Ausgang desselben (50, 52) zu messen, um den Faktor zu ermitteln.

**19.** Verfahren nach Anspruch 18, **dadurch gekennzeichnet, dass** das Verfahren umfasst, den Schritt (e) für jeden Differentialverstärker zu bewirken gemäß den Schritten:

(f) Verbinden des Ausgangs (50, 52) des Differentialverstärkers (14, 16) mit einem Analog-Digital-Wandler,
(g) Anlegen einer Spannung $V_A$, die auf den ersten und zweiten Kalibrierspannungen basiert, über den Eingängen (34, 36, 46, 48) des Differentialverstärkers (14, 16) und Messen von $V_A$,
(h) Messen der Ausgabe ($V_{ADC}$ ($V_A$)) des Analog-Digital-Wandlers (24), wenn $V_A$ an die Eingänge des Differentialverstärkers (14, 16) differentiell angelegt wird,
(i) Messen der Ausgabe ($V_{ADC}$ ($V_0$)) des Analog-Digital-Wandlers (24), wenn die Eingänge (34, 36, 46, 48) des Differentialverstärkers (14, 16) mit Masse verbunden sind, und
(j) Messen der Offset-Gleichspannung ($V_{OFF}$) an dem Ausgang (50, 52) des Differentialverstärkers (14, 16), wenn die Eingänge (34, 36, 46, 48) des Differentialverstärkers (14, 16) auf Masse gelegt werden.

**20.** Verfahren nach Anspruch 19, **dadurch gekennzeichnet, dass** das Verfahren ferner umfasst, eine kalibrierte gemessene Zellspannung ($V_R$) zu berechnen, um die wenigstens eine Zellspannung zu überwachen, wobei die gemessene Zellspannung ($V_R$) auf einer gemessenen Spannung basiert, die aus der Ausgabe ($V_{ADC}$) des Analog-Digital-Wandlers (24) erhalten wird, wenn die Eingänge (34, 36, 46, 48) des Differentialverstärkers (14, 16) über zwei der Anschlüsse angeschlossen sind, wobei die Berechnung ausgeführt wird gemäß:

$$V_R = \frac{V_A \cdot V_{ADC}}{[V_{ADC}(V_A) - V_{ADC}(V_0)]} - V_{OFF}$$

**21.** Verfahren nach Anspruch 13, **dadurch gekennzeichnet, dass** das Verfahren ferner umfasst, Differenzialverstärker (14, 16) bereitzustellen, die eine Gleichtaktspannung von 200 V sperren können.

**22.** Verfahren nach Anspruch 18, **dadurch gekennzeichnet, dass** das Verfahren ferner umfasst, die zweite Kalibrierspannung mit einem konstanten Spannungsinkrement hinsichtlich der ersten Kalibrierspannung bereitzustellen, um die Differenzspannung und die Gleichtaktspannung zu emulieren, die unter normalen Betriebsbedingungen an den Anschlüssen einer Zelle der Mehrzahl von elektrochemischen Zellen (18, 20) erwartet werden würden.

**23.** Verfahren nach Anspruch 21, **dadurch gekennzeichnet, dass** das Verfahren ferner umfasst, das konstante Spannungsinkrement in dem Bereich von 0,5 V bis 1 V auszuwählen.

**24.** Verfahren nach Anspruch 23, **dadurch gekennzeichnet, dass** das Verfahren ferner umfasst, das konstante Spannungsinkrement so auszuwählen, dass es 0,75 V beträgt.

**25.** Verfahren nach Anspruch 12, **dadurch gekennzeichnet, dass** das Verfahren ferner umfasst, die Zellspannung jeder der elektrochemischen Zellen (18, 20) nacheinander zu überwachen.

**26.** Verfahren nach Anspruch 12, **dadurch gekennzeichnet, dass** das Verfahren ferner umfasst, die Zellspannung von irgendeiner der elektrochemischen Zellen (18, 20) zu irgendeinem Zeitpunkt zu überwachen.

**27.** Verfahren nach Anspruch 12, **dadurch gekennzeichnet, dass** das Verfahren ferner umfasst, das Verfahren anzuwenden, um Brennstoffzellenspannungen zu messen.

**Revendications**

1.  Système (10) pour surveiller au moins une tension de pile d'un dispositif électrochimique, le dispositif ayant une pluralité de piles (18, 20) connectées en série, chaque pile mettant à disposition deux bornes, le système comprenant :

    une pluralité (12) d'amplificateurs différentiels, chaque amplificateur différentiel (14, 16) ayant deux entrées (34, 36, 46, 48) et une sortie (50, 52) dans laquelle chaque sortie (50, 52) de la pluralité (12) d'amplificateurs différentiels rejette une tension en mode commun élevé, les entrées d'au moins un parmi la pluralité (12) d'amplificateurs différentiels étant connectées, en utilisation, à deux des bornes pour mesurer une tension différentielle de cette dernière,
    un réseau (22) de commutation ayant une pluralité d'entrées et une sortie,
    un convertisseur (24) analogique-numérique ayant une entrée connectée à la sortie du réseau (22) de commutation,
    et dans lequel chacune parmi la pluralité d'entrées du réseau (22) de commutation est connectée à la sortie (50, 52) d'un parmi les amplificateurs différentiels (14, 16), le convertisseur analogique-numérique (24) étant adapté pour mettre à disposition des valeurs numériques indiquant la tension différentielle mesurée par le au moins un parmi la pluralité (12) d'amplificateurs différentiels,
    un dispositif de commande (26) connecté au réseau (22) de commutation et au convertisseur (24) analogique-numérique pour commander le fonctionnement du réseau (22) de commutation et du convertisseur (24) analogique-numérique, et pour recevoir les valeurs numériques, le système étant **caractérisé par** :

    un moyen de calcul, connecté à la sortie d'un parmi le convertisseur (24) analogique-numérique et le dispositif de commande (26), comprenant un moyen pour recevoir les valeurs numériques et appliquer un facteur aux valeurs numériques pour retirer une erreur quelconque de tension en mode commun de ces dernières.

2.  Système (10) selon la revendication 1, **caractérisé en ce que** chacun parmi l'amplificateur différentiel (14, 16) est adapté pour rejeter une tension en mode commun de 200 V.

3.  Système (10) selon la revendication 1, **caractérisé en ce que** le dispositif de commande (26) met à disposition le moyen de calcul.

4.  Système (10) selon la revendication 1, **caractérisé en ce que** le dispositif de commande (26) comprend un microprocesseur.

5.  Système (10) selon la revendication 1, **caractérisé en ce que** le système (10) comprend en outre un ordinateur (28) et le dispositif de commande (26) est connecté à l'ordinateur (28).

6.  Système (10) selon la revendication 1, **caractérisé en ce que** le moyen de calcul applique une équation linéaire pour retirer des erreurs des valeurs numériques, l'équation linéaire étant définie par calibrage pour au moins deux tensions d'entrée.

7.  Système (10) selon la revendication 6, **caractérisé en ce que** le système (10) comprend en outre au moins un calibrateur (70) pouvant être connecté à l'un parmi la pluralité (12) d'amplificateurs différentiels pour déterminer le facteur.

8.  Système (10) selon la revendication 7, **caractérisé en ce que** le au moins un calibrateur est adapté pour fournir deux tensions de calibrage aux entrées (50, 52) de l'un parmi la pluralité (12) d' amplificateurs différentiels, les deux tensions de calibrage étant décalées l'une par rapport à l'autre d'un incrément de tension constante pour émuler une tension différentielle et une tension en mode commun au niveau des bornes de l'une parmi la pluralité de piles (18, 20).

9.  Système (10) selon la revendication 8, **caractérisé en ce que** l'incrément de tension constante est choisi dans la plage s'étendant de 0,5 V à 1 V.

10. Système (10) selon la revendication 9, **caractérisé en ce que** l'incrément de tension constante est 0,75 V.

**EP 1 390 771 B1**

11. Système (10) selon la revendication 8, **caractérisé en ce que** le moyen de calcul applique le facteur aux valeurs numériques échantillonnées à partir des valeurs de tension mesurées par un amplificateur différentiel (14, 16) sélectionné à partir de la pluralité (12) d'amplificateurs différentiels selon :

$$V_R = \frac{V_A \bullet V_{CAN}}{[V_{CAN}(V_A) - V_{CAN}(V_0)]} - V_{ARRET}$$

où $V_A$ est une tension, basé sur les première et seconde tensions de calibrage, qui est appliquée sur les entrées de l'amplificateur différentiel (14, 16) sélectionné, $V_{CAN}(V_A)$ est la tension mesurée au niveau de la sortie du convertisseur (24) analogique-numérique lorsque $V_A$ est appliquée de manière différentielle sur les entrées (50, 52) de l'amplificateur différentiel (14, 16) sélectionné, $V_{CAN}(V_0)$ est la tension mesurée au niveau de la sortie du convertisseur (24) analogique-numérique lorsque les entrées (34, 36, 46, 48) de l'amplificateur différentiel (14, 16) sélectionné sont connectées à la terre, $V_{ARRET}$ est la tension décalée de courant continu mesurée au niveau de la sortie de l'amplificateur différentiel (14, 16) donné lorsque les entrées (34, 36, 46, 48) de l'amplificateur différentiel (14, 16) sont liées à la terre, et $V_{CAN}$ représente les valeurs numériques à partir desquelles les erreurs de tension en mode commun sont retirées.

12. Procédé pour surveiller au moins une tension de pile pour une pluralité de piles (18, 20) électrochimiques connectées en série, chacune parmi les piles (18, 20) électrochimiques ayant deux bornes, le procédé comprenant les étapes consistant à :

(a) connecter deux parmi les bornes de la pluralité de piles (18, 20) électrochimiques aux entrées (34, 36, 46, 48) d'un amplificateur différentiel (14, 16), l'amplificateur différentiel (14, 16) ayant deux entrées (34, 36, 46, 48) et une sortie (50, 52), les deux bornes fournissant une première et une seconde tensions ayant une tension en mode commun ;
(b) rejeter la tension en mode commun dans l'amplificateur différentiel (14, 16) pour mesurer une tension différentielle entre les deux bornes ;
(c) convertir la tension différentielle à partir d'une valeur analogique-numérique ; et **caractérisé par**
(d) l'application d'un facteur à la valeur numérique pour retirer une erreur de tension en mode commun de la tension différentielle.

13. Procédé selon la revendication 12, **caractérisé en ce que** l'étape (a) comprend en outre la mise à disposition d'une pluralité (12) d'amplificateurs différentiels, chaque amplificateur différentiel (14, 16) ayant deux entrées (34, 36, 46, 48) et une sortie (50, 52), et la connexion des paires supplémentaires de bornes à partir de la pluralité de piles (18, 20) électrochimiques sur la pluralité (12) d'amplificateurs différentiels, chacune parmi les paires de bornes étant connectée à des entrées (34, 36, 46, 48) d'un parmi la pluralité d'amplificateurs différentiels (14, 16), les paires supplémentaires de bornes ayant chacune une tension en mode commun ; et l'exécution des étapes (b), (c), et (d) pour chacun parmi les amplificateurs différentiels (14, 16).

14. Procédé selon la revendication 13, **caractérisé en ce que** le procédé comprend en outre la connexion des sorties (50, 52) des amplificateurs différentiels (14, 16) au travers d'un réseau (22) de commutation à un convertisseur (24) analogique-numérique, en utilisant le réseau (22) de commutation pour commuter la sortie (50, 52) d'un des amplificateurs différentiels (14, 16) sur le convertisseur (24) analogique-numérique pour une conversion analogique-numérique de la tension différentielle au niveau de la sortie de l'amplificateur différentiel (14, 16).

15. Procédé selon la revendication 14, **caractérisé en ce que** le procédé comprend en outre la mise à disposition d'un dispositif de commande (26) pour commander le réseau (22) de commutation et le convertisseur (24) analogique-numérique.

16. Procédé selon la revendication 15, **caractérisé en ce que** le procédé comprend en outre la mise à disposition du dispositif de commande (26) en tant qu'un microprocesseur.

17. Procédé selon la revendication 12, **caractérisé en ce que** l'étape (d) comprend l'application d'une équation linéaire pour retirer des erreurs de la valeur numérique, l'équation linéaire étant définie par un calibrage pour au moins deux tensions d'entrée.

18. Procédé selon la revendication 12 ou 13, **caractérisé en ce que** le procédé comprend en outre l'étape consistant à :

**15**

(e) mettre à disposition des première et seconde tensions de calibrage connues, à partir d'un calibrateur, pour les entrées de chaque amplificateur différentiel (14, 16) et mesurer la tension au niveau de la sortie (50, 52) de ce dernier pour déterminer le facteur.

**19.** Procédé selon la revendication 18, **caractérisé en ce que** le procédé comprend l'exécution d'une étape (e) pour chaque amplificateur différentiel (14, 16) selon les étapes consistant à :

(f) connecter la sortie (50, 52) de l'amplificateur différentiel (14, 16) à un convertisseur analogique-numérique ;
(g) appliquer une tension $V_A$, basée sur les première et seconde tensions de calibrage, sur les entrées (34, 36, 46, 48) de l'amplificateur différentiel (14, 16) et mesurer $V_A$ ;
(h) mesurer la sortie ($V_{CAN}(V_A)$) du convertisseur (24) analogique-numérique, lorsque $V_A$ est appliquée de manière différentielle sur les entrées de l'amplificateur différentiel (14, 16) ;
(i) mesurer la sortie ($V_{CAN}(V_0)$) du convertisseur (24) analogique-numérique lorsque les entrées (34, 36, 46, 48) de l'amplificateur différentiel (14, 16) sont connectées à la terre ; et
(j) mesurer la tension $V_{ARRET}$ décalée de courant continu au niveau de la sortie (50, 52) de l'amplificateur différentiel (14, 16) lorsque les entrées (34, 36, 46, 48) de l'amplificateur différentiel (14, 16) sont liées à la terre.

**20.** Procédé selon la revendication 19, **caractérisé en ce que** le procédé comprend en outre le calcul d'une tension ($V_R$) de pile mesurée calibrée pour surveiller la au moins une tension de pile, la tension ($V_R$) de pile mesurée calibrée étant basée sur une tension mesurée obtenue à partir de la sortie ($V_{CAN}$) du convertisseur (24) analogique-numérique lorsque les entrées (34, 36, 46, 48) de l'amplificateur différentiel (14, 16) sont connectées sur deux des bornes, dans lequel le calcul est effectué selon :

$$V_R = \frac{V_A \bullet V_{CAN}}{[V_{CAN}(V_A) - V_{CAN}(V_0)]} - V_{ARRET}$$

**21.** Procédé selon la revendication 13, **caractérisé en ce que** le procédé comprend en outre la mise à disposition des amplificateurs différentiels (14, 16), qui peuvent rejeter une tension en mode commun de 200 V.

**22.** Procédé selon la revendication 18, **caractérisé en ce que** le procédé comprend en outre la mise à disposition de la seconde tension de calibrage avec un incrément de tension constante par rapport à la première tension de calibrage pour émuler la tension différentielle et la tension en mode commun qui seraient attendues, dans des conditions normales de fonctionnement, au niveau des bornes d'une pile de la pluralité de piles (18, 20) électrochimiques.

**23.** Procédé selon la revendication 21, **caractérisé en ce que** le procédé comprend en outre le choix de l'incrément de tension constante dans la plage s'étendant de 0,5 V à 1 V.

**24.** Procédé selon la revendication 23, **caractérisé en ce que** le procédé comprend en outre le choix de l'incrément de tension constante pour qu'il soit de 0,75 V.

**25.** Procédé selon la revendication 12, **caractérisé en ce que** le procédé comprend en outre la surveillance séquentielle de la tension de pile de chacune parmi les piles (18, 20) électrochimiques.

**26.** Procédé selon la revendication 12, **caractérisé en ce que** le procédé comprend en outre la surveillance de la tension de pile de l'une quelconque des piles (18, 20) électrochimique à un moment quelconque.

**27.** Procédé selon la revendication 12, **caractérisé en ce que** le procédé comprend en outre l'application du procédé pour la mesure de tensions de piles à combustible.

**FIG. 1** (Prior Art)

Figure 2

Fuel Cell Stack — 13, 38, 18, 40, 42, 20, 44

Plurality of Differential Amplifiers — 34, 14, 36, 46, 16, 48, 12

Switching Network — 22, 50, 52

Analog to Digital Converter (ADC) — 24

Controller — 26

A/D Control — 49

Multiplexer Control — 47

PC — 28

RS-232 — 30

10

EP 1 390 771 B1

18

Figure 3a

Figure 3b

EP 1 390 771 B1